(19)

**Europäisches Patentamt**

**European Patent Office**

**Office européen des brevets**

(11) **EP 4 783 392 A1**

(12) **EUROPEAN PATENT APPLICATION**

(43) Date of publication:
29.07.2026 Bulletin 2026/31

(51) International Patent Classification (IPC):
*H02H 3/093* (2006.01)     *H02H 6/00* (2006.01)
*H02H 7/22* (2006.01)      *H03K 17/08* (2006.01)

(21) Application number: 26305096.5

(22) Date of filing: 22.01.2026

(52) Cooperative Patent Classification (CPC):
**H02H 3/0935; H02H 6/00; H02H 7/222;**
**H03K 17/0822; H03K 17/0824; H03K 17/0828;**
H03K 2017/0806

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: 26.01.2025 CN 202510124965

(71) Applicant: **SCHNEIDER ELECTRIC INDUSTRIES
SAS**
**92500 Rueil-Malmaison (FR)**

(72) Inventors:
• **SHI, Ying**
**Shanghai 201203 (CN)**

• **WANG, Hao**
**Shanghai 201203 (CN)**
• **LIU, Xia**
**Shanghai 201203 (CN)**
• **SHUANG, Bing**
**Shanghai 201203 (CN)**
• **DING, Jiaojiao**
**Wuxi city (CN)**
• **ZHAO, Haijun**
**Shanghai 201203 (CN)**

(74) Representative: **Plasseraud IP**
**104 Rue de Richelieu**
**CS92104**
**75080 Paris Cedex 02 (FR)**

(54) **OVER-TEMPERATURE PROTECTION METHOD AND APPARATUS, DEVICE, AND STORAGE MEDIUM FOR SOLID-STATE CIRCUIT BREAKER**

(57) An over-temperature protection method (600) and apparatus (700), a device (800) and a storage medium for a solid-state circuit breaker. The method (600) includes: determining (610) a time constant indicative of an association between a temperature rise amount and an operating time of a solid-state circuit breaker operating at a predetermined operating current; determining (620) a first temperature rise amount based on a temperature rise amount detected before the solid-state circuit breaker is turned off, a duration for which the solid-state circuit breaker is turned off, and the time constant; determining (630) a second temperature rise amount based on the first temperature rise amount, the time constant, and an operating current detected after the solid-state circuit breaker is turned on; and controlling (640) a turn-on state of the solid-state circuit breaker based on a comparison between the second temperature rise amount and a predetermined threshold.

FIG. 6

## Description

### FIELD

Embodiments of the present disclosure relate to the field of electrical devices, and in particular to an over-temperature protection method and apparatus, a device, and a storage medium for a solid-state circuit breaker.

### BACKGROUND

In an application of a Direct Current (DC) microgrid, the overload protection of a converter of a power supply and load focuses more on selectivity rather than being equivalent to cable protection since the converter itself may limit the overcurrent under overload conditions. With the solid-state circuit breaker applied in the DC microgrid, the selectivity under short circuit and overload conditions can be better realized. However, the solid-state circuit breaker has limited capability to withstand the overcurrent, and the temperature measurement of the solid-state circuit breaker is difficult.

### SUMMARY

An object of the present disclosure is to provide an over-temperature protection solution for a solid-state circuit breaker to at least partially solve the above problems.

In a first aspect of the present disclosure, an over-temperature protection method for a solid-state circuit breaker is provided. The over-temperature protection method includes: determining a time constant indicative of an association between a temperature rise amount and an operating time of the solid-state circuit breaker operating at a predetermined operating current, where the temperature rise amount indicates a change value of a device temperature of the solid-state circuit breaker at the predetermined operating current, and the predetermined operating current is no less than a rated operating current of the solid-state circuit breaker; determining a first temperature rise amount of the solid-state circuit breaker based on a temperature rise amount detected before the solid-state circuit breaker is turned off, a duration for which the solid-state circuit breaker is turned off, and the time constant, where the first temperature rise amount indicates a current change value of the device temperature after the solid-state circuit breaker has operated for a first duration; determining a second temperature rise amount of the solid-state circuit breaker based on the first temperature rise amount, the time constant, and an operating current detected after the solid-state circuit breaker is turned on, where the second temperature rise amount indicates a change value of a device temperature of the solid-state circuit breaker after the solid-state circuit breaker has operated for a second duration; and controlling a turn-on state of the solid-state circuit breaker based on a comparison between the second temperature rise amount and a predetermined threshold.

In a second aspect of the present disclosure, an over-temperature protection apparatus for a solid-state circuit breaker is provided. The over-temperature protection apparatus includes: a time constant determination module configured to determine a time constant indicative of an association between a temperature rise amount and an operating time of the solid-state circuit breaker operating at a predetermined operating current, where the temperature rise amount indicates a change value of a device temperature of the solid-state circuit breaker at the predetermined operating current, and the predetermined operating current is no less than a rated operating current of the solid-state circuit breaker; a first temperature rise amount determination module configured to determine a first temperature rise amount of the solid-state circuit breaker based on a temperature rise amount detected before the solid-state circuit breaker is turned off, a duration for which the solid-state circuit breaker is turned off, and the time constant, where the first temperature rise amount indicates a current change value of the device temperature of the solid-state circuit breaker after the solid-state circuit breaker has operated for a first duration; a second temperature rise amount determination module configured to determine a second temperature rise amount of the solid-state circuit breaker based on the first temperature rise amount, the time constant, and an operating current detected after the solid-state circuit breaker is turned on, where the second temperature rise amount indicates a change value of a device temperature of the solid-state circuit breaker after the solid-state circuit breaker has operated for a second duration; and a circuit breaker control module configured to control a turn-on state of the solid-state circuit breaker based on a comparison between the second temperature rise amount and a predetermined threshold.

In a third aspect of the present disclosure, an electronic device is provided. The electronic device includes at least one processing unit; and at least one memory coupled to the at least one processing unit and storing instructions for execution by the at least one processing unit, the instructions, when executed by the at least one processing unit, causing the electronic device to perform the method of the first aspect of the present disclosure.

In a fourth aspect of the present disclosure, a computer-readable storage medium is provided. The computer-readable storage medium has a computer program stored thereon, and the computer program is executable by a processor to perform the method of the first aspect of the present disclosure.

It should be understood that the content described in this summary section is not intended to limit the key features or major features of the embodiments of the present disclosure, nor is it intended to limit the scope of the present disclosure. Other features of the present disclosure will become readily understood from the following description.

**BRIEF DESCRIPTION OF DRAWINGS**

The above and other features, advantages, and aspects of various embodiments of the present disclosure will become more apparent from the following detailed description taken in conjunction with the accompanying drawings. In the drawings, the same or similar reference numbers refer to the same or similar elements, where:

FIG. 1 illustrates a schematic diagram of an example circuit for over-temperature protection according to some embodiments of the present disclosure;
FIG. 2 illustrates a schematic diagram of a thermal simulation table of a solid-state circuit breaker operating at a plurality of predetermined operating currents according to some embodiments of the present disclosure;
FIG. 3 illustrates a schematic diagram of a temperature rise curve of a solid-state circuit breaker operating at a predetermined operating current according to some embodiments of the present disclosure;
FIG. 4 illustrates a schematic diagram of a temperature rise curve and a time constant fitting curve of a solid-state circuit breaker operating at a predetermined operating current according to some embodiments of the present disclosure;
FIG. 5 illustrates a schematic diagram of an over-temperature trip curve and an overload limit curve of a solid-state circuit breaker according to some embodiments of the present disclosure;
FIG. 6 illustrates a flowchart of a process for over-temperature protection of a solid-state circuit breaker according to some embodiments of the present disclosure;
FIG. 7 illustrates a block diagram of an apparatus for over-temperature protection of a solid-state circuit breaker according to some embodiments of the present disclosure; and
FIG. 8 illustrates a block diagram of an electronic device in which one or more embodiments of the present disclosure may be implemented.

**DETAILED DESCRIPTION**

Preferred embodiments of the present disclosure will be described in more detail below with reference to the accompanying drawings. While the preferred embodiments of the present disclosure are shown in the drawings, it should be understood that the present disclosure may be implemented in various forms and should not be limited by the embodiments set forth herein. Rather, these embodiments are provided to make the present disclosure more thorough and complete, and to fully convey the scope of the present disclosure to those skilled in the art.

As used herein, the term "including" and variations thereof represent open-ended inclusions, i.e., "including but not limited to". Unless specifically stated, the term "or" refers to "and/or". The term "based on" refers to "based at least in part on". The terms "an example embodiment" and "an embodiment" refer to "at least one example embodiment". The term "another embodiment" refers to "at least one further embodiment". The terms "first", "second", and the like may refer to different or identical objects.

As described above, in an application of a DC microgrid, the overload protection of a converter of a power and load focuses more on selectivity rather than being equivalent to cable protection since the converter itself may limit the overload current under overload conditions. With the solid-state circuit breaker applied in the DC microgrid, the selectivity under short circuit and overload conditions can be better realized. However, the solid-state circuit breaker has limited capability to withstand the overcurrent, and the temperature measurement of the solid-state circuit breaker is difficult.

In a conventional temperature measurement solution, a temperature sensor is usually used to measure temperature of a power electronic switch element such as a metal oxide semiconductor field effect transistor (MOSFET), an insulated gate bipolar transistor (IGBT), and a thyristor in a solid-state circuit breaker. However, a response time of the temperature sensor is long, which may not accurately reflect the real-time junction temperature of the power electronic switch. In addition, such detection modes are easily limited by the structure. If the product has a small dimension and an insufficient installation space, this detection mode cannot be used.

To this end, embodiments of the present disclosure provide a solution for over-temperature protection of a solid-state circuit breaker. In this solution, a time constant indicative of an association between a temperature rise amount and an operating time of the solid-state circuit breaker operating at a predetermined operating current is determined, the temperature rise amount indicates a change value of a device temperature of the solid-state circuit breaker at the predetermined operating current, and the predetermined operating current is no less than a rated operating current of the solid-state circuit breaker. Then, a first temperature rise amount of the solid-state circuit breaker is determined based on a temperature rise amount detected before the solid-state circuit breaker is turned off, a duration for which the solid-state circuit breaker is turned off, and the time constant, and the first temperature rise amount indicates a current change value of the device temperature of the solid-state circuit breaker after the solid-state circuit breaker has operated for a first duration. Then, a second temperature rise amount of the solid-state circuit breaker is determined based on the first temperature rise amount, the time constant and an operating current detected after the solid-state circuit breaker is turned on, and the second temperature rise amount indicates a change value of a device temperature of the solid-state circuit breaker after the solid-state circuit breaker has operated for a second duration. Thus, a turn-on state of the solid-state circuit breaker is controlled based on a comparison between the second temperature rise amount and a predetermined threshold.

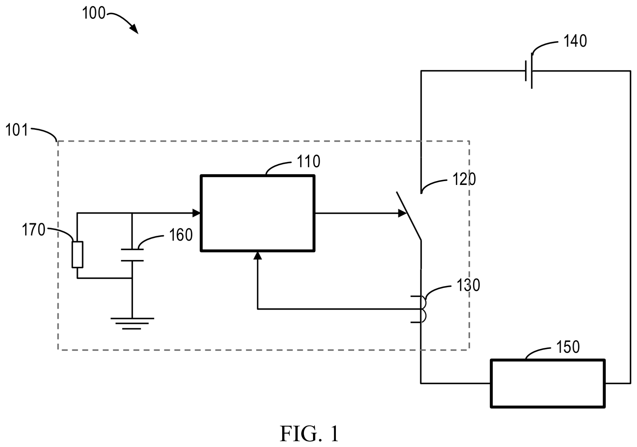

In this way, the real-time junction temperature of the power electronic switch of the solid-state circuit breaker can be inferred only according to the calculation of electrical parameters, so that the turn-off can be controlled in time. There is no need to additionally install a temperature measurement element, and the condition that the real-time temperature measurement cannot be performed due to the insufficient installation space can be avoided. Hereinafter, the principles of the present disclosure will be described with reference to FIGS. 1 to 8.

FIG. 1 illustrates a schematic diagram of an example circuit 100 for over-temperature protection according to some embodiments of the present disclosure. As shown in FIG. 1, the example circuit 100 described herein generally includes a power supply 140, a load 150, and a solid-state circuit breaker 101. The solid-state circuit breaker 101 includes a control unit 110, a switch element 120, a current measurement element 130, an energy storage capacitor 160, and a resistor 170. The switch element 120 is connected between the power supply 140 and the load 150 and is capable of being turned on and off under the control of the control unit 110. The current measurement element 130 is connected in series with the switch element 120 to measure the magnitude of a current on a main loop where the switch element 120 is located. The energy storage capacitor 160 is connected to the main loop. With the switch element 120 being turned on, the energy storage capacitor 160 may be charged. With the switch element 120 being turned off, the energy storage capacitor 160 may be discharged through the resistor 170 connected in parallel therewith. In such cases, the control unit 110 may detect a drop in the temperature rise amount of the solid-state circuit breaker 101. In this way, the control unit 110 may detect, through the energy storage capacitor 160, an initial temperature rise amount $\theta_0$ when the switch element 120 is turned on again.

In some embodiments, the control unit 110 may be a micro control unit (MCU). The control unit 110 may control the switch element 120 to be turned off under a control condition such as a temperature rise amount of the switch element 120 exceeding a predetermined threshold. In some embodiments, the control unit 110 may include a storage unit. The storage unit may store, in the case that the switch element 120 is turned off, a value of the temperature rise amount $\theta_{prev}$ before the switch element 120 is turned off.

In some embodiments, the control unit 110 may further include a timing unit. The timing unit is capable of calculating a duration t for which the switch element 120 is turned off according to a voltage across the energy storage capacitor 160. It should be understood that, based on the teaching provided by the present disclosure, a person of ordinary skill in the art may conceive of other types of control units to implement the foregoing functions, and these implementations all fall within the scope of the present disclosure.

In some embodiments, the switch element 120 may be a MOSFET. The MOSFET is able to be turned on and off under the control of the control unit 110 to conduct and disconnect the main loop. MOSFET has different speeds of temperature rise at different operating currents. When the temperature of the device is too high, the MOSFET will be controlled to be turned off, that is, the switch element 120 is tripped. It may be understood that the switch element 120 provided by the embodiments of the present disclosure may implement the foregoing functions by using any suitable type of power electronic switch element, for example, an IGBT, a thyristor, or the like. The principle of the present disclosure will be described in detail below taking the MOSFET as the switch element 120 as an example.

In some embodiments, the current measurement element 130 may be a current transformer. The control unit 110 may measure an operating current $I(n)$ on the main loop in real time according to the current measurement element 130. It should be understood that the above functions may also be implemented by other types of current measurement elements, such as Rogowski coils, shunts, Hall elements, tunnel magnetoresistance (TMR), giant magnetoresistance (GMR), anisotropic magnetoresistance (AMR), or other sensors based on magneto-resistive technology, that can be conceived by those skilled in the art, based on the teachings presented in the present disclosure, and these implementations all fall within the scope of the present disclosure.

It should be understood that the example circuit 100 shown in FIG. 1 is merely illustrative but not limiting. The main loop in which the switch element 120 is located may also include any suitable number of electronic components configured to implement example embodiments of the present disclosure. Although not shown, it should be understood that one or more other elements may be provided in the example circuit 100.

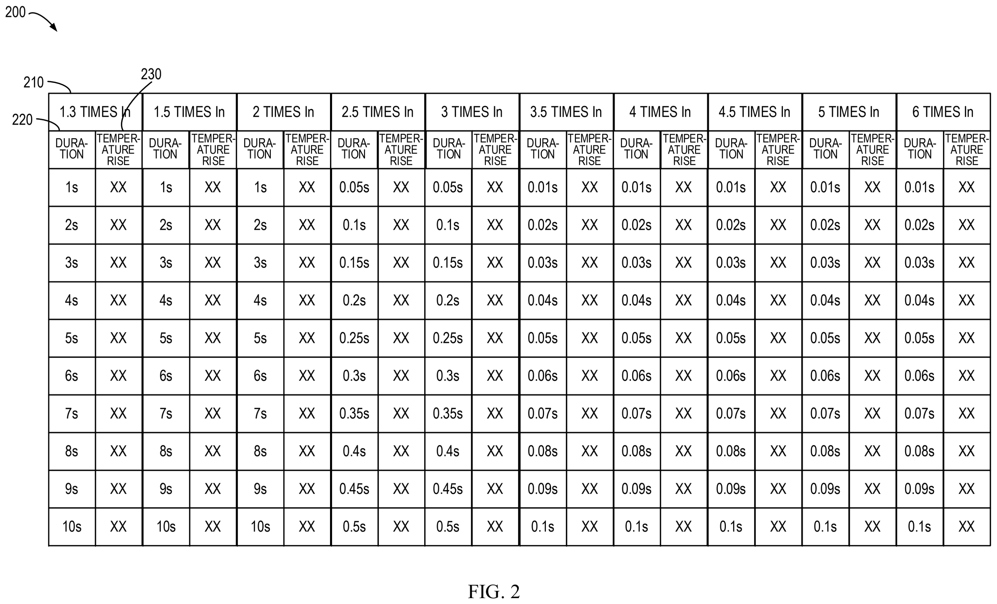

FIG. 2 illustrates a schematic diagram of a thermal simulation table 200 of the switch element 120 operating at a plurality of predetermined operating currents according to some embodiments of the present disclosure. By performing thermal simulation on the switch element 120 as shown in FIG. 1, that is, the switch element 120 operating at different predetermined operating currents until the thermal stability is achieved, an association relationship between an operating duration of the switch element 120 and a corresponding predetermined operating current may be obtained.

In some embodiments, the plurality of predetermined operating currents may be in a multiple relationship with a rated operating current of the switch element 120. As shown in the thermal simulation table 200 of FIG. 2, the rated operating current of the switch element 120 is *In,* and a plurality of predetermined operating currents 210 may include 1.3 times *In,* 1.5 times *In,* 2 times *In,* 2.5 times *In,* 3 times *In,* 3.5 times *In,* 4 times *In,* 4.5 times *In,* 5 times *In,* 6 times *In,* and/or the like. For the thermal simulation under each predetermined operating current 210, a duration 220 for which the switch element 120 has operated and a temperature rise 230 of the switch element 120 may be set to reflect the temperature rise situation of the switch element 120 after it has operated for a certain duration at the predetermined operating current 210.

In some embodiments, the switch element 120 may be controlled to be turned off by the control unit 110 when the temperature rise amount reaches a predetermined threshold. The predetermined threshold is a junction temperature threshold of the switch element 120. For example, the predetermined threshold may be 32 Kelvin (K). It should be understood that the number and the value of the predetermined operating current 210 described above are merely examples, and any suitable current may be selected as the predetermined operating current according to the type of the switch element 120 and the actual operating condition, which is not limited in the present disclosure.

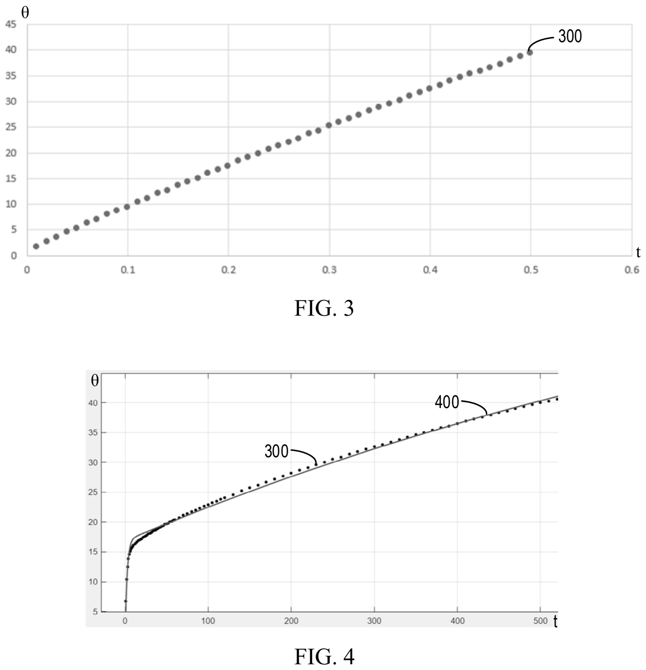

FIG. 3 illustrates a schematic diagram of a temperature rise curve 300 of the switch element 120 operating at a predetermined operating current according to some embodiments of the present disclosure. Based on the thermal simulation for the switch element 120 at each predetermined operating current 210 as described above, the temperature rise curve 300 as shown in FIG. 3 may be obtained.

In some embodiments, the abscissa of the temperature rise curve 300 indicates the operating duration of the switch element 120 at the predetermined operating current 210. The ordinate of the temperature rise curve 300 indicates the temperature rise amount of the switch element 120 at the predetermined operating current 210.

In some embodiments, as shown in FIGS. 2 and 3, for the thermal simulation at each predetermined operating current 210, there is a time interval *Te* between durations 220 corresponding to the predetermined operating current 210. For example, in a case where the predetermined operating current 210 is 1.5 times *In,* the time interval *Te* between the durations 220 is 1 second (s). For another example, in a case where the predetermined operating current 210 is 3.5 times *In,* the time interval *Te* between the durations 220 is 0.01s.

FIG. 4 illustrates a schematic diagram of a temperature rise curve 300 and a time constant fitting curve 400 of the switch element 120 operating at a predetermined operating current 210 according to some embodiments of the present disclosure. Based on the temperature rise curve 300 of the switch element 120 operating at each predetermined operating current 210, the time constant fitting curve 400 may be obtained by fitting. The time constant fitting curve 400 indicates an association between an operating time and a temperature rise amount of the solid-state circuit breaker operating at the predetermined operating current 210.

In some embodiments, the time constant fitting curve 400 corresponds to a first-type time constant and a pair of second-type time constants. The first-type time constant may be a single time constant *tau.* The pair of second-type time constants may be double time constants *tau1* and *tau2.* The fitting curve of the double time constants *tau1* and *tau2* can accurately reflect the temperature rise change of the switch element 120 at the initial stage of operation. The single time constant *tau* can accurately reflect the temperature rise change of the switch element 120 after it has operated for a certain duration.

In some embodiments, in addition to the predetermined operating current 210, time constants corresponding to other operating currents may be determined by way of an interpolation algorithm. For example, a linear interpolation algorithm or an exponential interpolation algorithm may be used to calculate time constants corresponding to other operating currents.

In the case that the linear interpolation algorithm is used, a first operating current $x_1$ of the plurality of predetermined operating currents 210, a time constant $y_1$ corresponding to the first operating current $x_1$, a second operating current $x_0$ of the plurality of predetermined operating currents 210, a time constant $y_0$ corresponding to the second operating current $x_0$, and a third operating current x which lies between the first operating current $x_1$ and the second operating current $x_0$ but is not included in the plurality of predetermined operating currents 210 are taken, and a time constant y corresponding to the third operating current x may be determined by the following formula:

$$y = \frac{(x - x_0) * (y_1 - y_0)}{(x_1 - x_0)} + y_0$$

In the case that the exponential interpolation algorithm is used, the time constant *y* corresponding to the third operating current x may be determined by the following formula:

$$y = e^{\frac{(x-x_0)*(\log(y_1)-\log(y_0))}{(x_1-x_0)}+\log(y_0)}$$

In this way, the time constant indicative of the association between the temperature rise amount and the operating time of the switch element 120 operating at any operating current may be determined.

As described above, the control unit 110 may detect the temperature rise amount $\theta_{prev}$ before the switch element 120 is turned off by the energy storage capacitor 160, and the timing unit in the control unit 110 is capable of calculating the duration t for which the switch element 120 is turned off according to the voltage across the energy storage capacitor 160. In the case that the single time constant *tau* is obtained through the above steps, the initial temperature rise amount $\theta_0$ of the switch element 120 within a predetermined time may be determined by the following formula:

$$\theta_0 = \theta_{prev} \cdot e^{-\frac{t}{tau}}$$

In the case that the double time constants *tau1* and *tau2* are obtained by the above steps, the initial temperature rise amount $\theta_0$ of the switch element 120 within the predetermined time may be determined by the following formula:

$$\theta_0 = \theta_{prev} \cdot \left( \alpha \cdot e^{-\frac{t}{tau1}} + (1 - \alpha) \cdot e^{-\frac{t}{tau2}} \right)$$

where $\alpha$ is a constant associated with *tau1* and *tau2*.

Based on the operating current *I(n)* of the switch element 120 measured in real time by the current measurement element 130, the real-time temperature rise amount $\theta_{(n)}$ of the switch element 120 may be determined by the following formula:

$$\theta(n) = \alpha \cdot I(n)^2 + (1 - \alpha) \cdot \theta(n - 1)$$

where $\alpha$ is a constant associated with *tau*. When $n = 1$, $\theta_0$ refers to $\theta_0$ determined via the single time constant *tau*.

In some embodiments, a capacitance value of the energy storage capacitor 160 and a resistance value of the resistor 170 may be determined according to the time constant. When the time constant corresponding to the capacitance value of the energy storage capacitor 160 and the resistance value of the resistor 170 is consistent with the time constant determined in the above process, the control unit 110 may store, on the energy storage capacitor 160, the temperature rise amount $\theta_{prev}$ before the turn-off in the form of a voltage. After the switch element 120 has been turned off for a duration *t,* the control unit 110 may directly determine $\theta_0$ by detecting the voltage across the energy storage capacitor 160 at this time.

In this way, the control unit 110 may calculate the device temperature of the switch element 120 when the operating current *I(n)* is merely measured, to control the switch element 120 to be tripped in time if the device temperature is too high. There is no need to additionally install the temperature measurement element, and the condition that the real-time temperature measurement cannot be performed due to the insufficient installation space can be avoided.

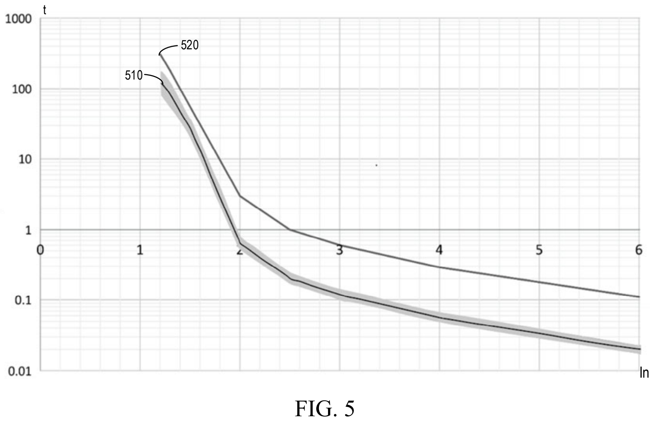

FIG. 5 illustrates a schematic diagram of an over-temperature trip curve 510 and an overload limit curve 520 of the switch element 120 according to some embodiments of the present disclosure. In the above thermal simulation process for the switch element 120, a plurality of operating durations for the temperature rise amount of the switch element 120 operating at a plurality of predetermined operating currents to reach a predetermined threshold may be determined. According to the association relationship between the plurality of operating durations and the plurality of predetermined operating currents, the over-temperature trip curve 510 of the switch element 120 shown in FIG. 5 may be obtained. Depending on the type and characteristics of the MOSFET of the switch element 120, the overload limit curve 520 as shown in FIG. 5 may be obtained. It should be understood that with different types of solid-state switch devices, capacities of the switch elements 120 to withstand the overcurrent may be different, and the overload limit curve 520 may also be different.

In some embodiments, in the case that the current measurement element 130 measures the operating current *I(n)* of the switch element 120, the control unit 110 may calculate a duration for the temperature rise amount of the switch element 120 at the operating current *I(n)* to reach a predetermined threshold according to the over-temperature trip curve 510, and control the switch element 120 to be turned off if the switch element 120 has operated for the third duration, thereby performing over-temperature protection.

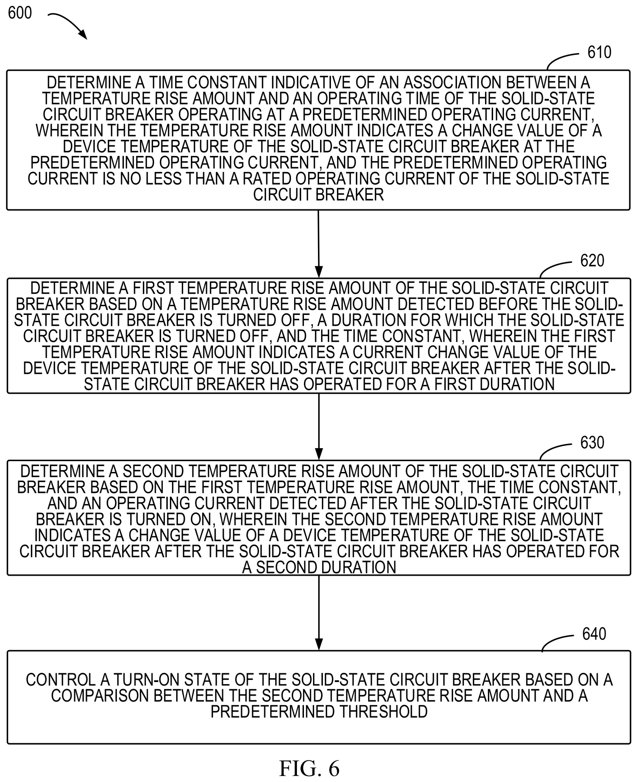

FIG. 6 illustrates a flowchart of a process 600 for over-temperature protection of a solid-state circuit breaker according to some embodiments of the present disclosure. The process 600 may be implemented at the control unit 110 as shown in FIG. 1.

At block 610, a time constant indicative of an association between a temperature rise amount and an operating time of the solid-state circuit breaker operating at a predetermined operating current is determined, where the temperature rise amount indicates a change value of a device temperature of the solid-state circuit breaker at the predetermined operating current, and the predetermined operating current is no less than a rated operating current of the solid-state circuit breaker.

At block 620, a first temperature rise amount of the solid-state circuit breaker is determined based on a temperature rise amount detected before the solid-state circuit breaker is turned off, a duration for which the solid-state circuit breaker is turned off, and the time constant, where the first temperature rise amount indicates a current change value of the device temperature of the solid-state circuit breaker after the solid-state circuit breaker has operated for a first duration.

At block 630, a second temperature rise amount of the solid-state circuit breaker is determined based on the first temperature rise amount, the time constant, and an operating current detected after the solid-state circuit breaker is turned on, where the second temperature rise amount indicates a change value of a device temperature of the solid-state circuit breaker after the solid-state circuit breaker has operated for a second duration.

At block 640, a turn-on state of the solid-state circuit breaker is controlled based on a comparison between the second temperature rise amount and a predetermined threshold.

In some embodiments, the predetermined operating current is one of a plurality of predetermined operating currents, and determining the time constant indicative of the association between the temperature rise amount and the operating time of the solid-state circuit breaker operating at the predetermined operating current includes: determining a plurality of temperature rise amounts of the solid-state circuit breaker operating at the plurality of predetermined operating currents, each of the plurality of temperature rise amounts corresponding to one of the plurality of predetermined operating currents; and determining, based on the plurality of temperature rise amounts, a plurality of time constants indicative of associations between temperature rise amounts and operating times of the solid-state circuit breaker operating at the plurality of predetermined operating currents, respectively.

In some embodiments, the process 600 further includes: determining a first time constant and a second time constant of the plurality of time constants respectively corresponding to a first operating current and a second operating current; and determining, based on the first operating current, the second operating current, the first time constant, the second time constant, and a third operating current, a third time constant indicative of an association between a temperature rise amount and an operating time of the solid-state circuit breaker operating at the third operating current, the plurality of predetermined operating currents excluding the third operating current.

In some embodiments, the process 600 further includes: determining, based on comparisons between the plurality of temperature rise amounts and the predetermined threshold, a plurality of operating durations of the solid-state circuit breaker in accordance with the plurality of temperature rise amounts reaching the predetermined threshold; and determining an association relationship between the plurality of operating time durations and the plurality of predetermined operating currents.

In some embodiments, controlling the turn-on state of the solid-state circuit breaker includes: determining, based on the association relationship, a third duration for which the solid-state circuit breaker has operated in accordance with the temperature rise amount of the solid-state circuit breaker operating at the first operating current of the plurality of predetermined operating currents reaching the predetermined threshold; and controlling the solid-state circuit breaker to be turned off in response to the solid-state circuit breaker have operated for the third duration.

In some embodiments, the time constant includes a first-type time constant and a pair of second-type time constants, and determining the first temperature rise amount of the solid-state circuit breaker includes: determining the first temperature rise amount based on the temperature rise amount detected before the solid-state circuit breaker is turned off, the duration for which the solid-state circuit breaker is turned off, and the first-type time constant; or determining the first temperature rise amount based on the temperature rise amount detected before the solid-state circuit breaker is turned off, the duration for which the solid-state circuit breaker is turned off, and the pair of second-type time constants.

In some embodiments, determining the second temperature rise amount of the solid-state circuit breaker includes: determining the second temperature rise amount based on the first temperature rise amount, the first-type time constant, and the operating current detected after the solid-state circuit breaker is turned on.

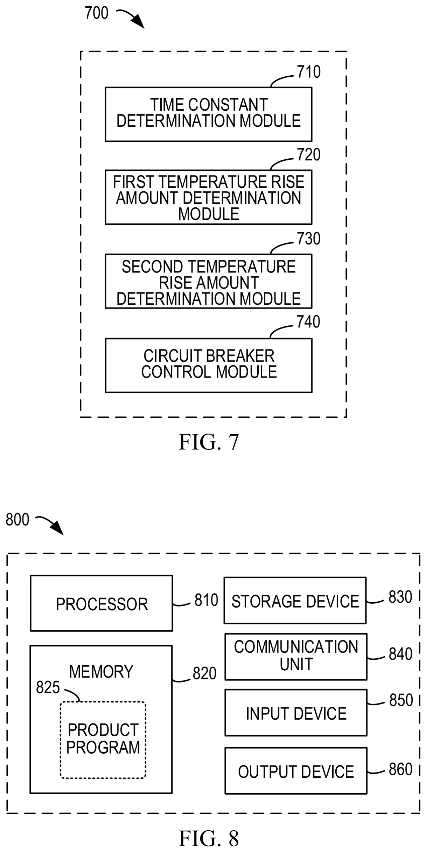

FIG. 7 illustrates a block diagram of an apparatus 700 for over-temperature protection of a solid-state circuit breaker according to some embodiments of the present disclosure. The apparatus 700 may be implemented, for example, in the control unit 110. Various modules/components in the apparatus 700 may be implemented by hardware, software, firmware, or any combination thereof.

The apparatus 700 includes a time constant determination module 710 configured to determine a time constant indicative of an association between a temperature rise amount and an operating time of the solid-state circuit breaker operating at a predetermined operating current, where the temperature rise amount indicates a change value of a device temperature of the solid-state circuit breaker at the predetermined operating current, and the predetermined operating current is not less than a rated operating current of the solid-state circuit breaker. The apparatus 700 further includes a first temperature rise amount determination module 720 configured to determine a first temperature rise amount of the solid-state circuit breaker based on a temperature rise amount detected before the solid-state circuit breaker is turned off, a duration for which the solid-state circuit breaker is turned off, and the time constant, where the first temperature rise amount indicates a current change value of the device temperature of the solid-state circuit breaker after the solid-state circuit breaker has operated for a first duration. The apparatus 700 further includes a second temperature rise amount determination module 730 configured to determine a second temperature rise amount of the solid-state circuit breaker based on the first temperature rise amount, the time constant, and an operating current detected after the solid-state circuit breaker is turned on, where the second temperature rise amount indicates a change value of a device temperature of the solid-state circuit breaker after the solid-state circuit breaker has operated for a second duration. The apparatus 700 further includes a circuit breaker control module 740 configured to control a turn-on state of the solid-state circuit breaker based on a comparison between the second temperature rise amount and a predetermined threshold.

In some embodiments, the predetermined operating current is one of a plurality of predetermined operating currents, and the time constant determination module 710 includes: a temperature rise amount determination module 711 configured to determine a plurality of temperature rise amounts of the solid-state circuit breaker operating at the plurality of predetermined operating currents, each of the plurality of temperature rise amounts corresponding to one of the plurality of predetermined operating currents; and a multi-constant determination module 712 configured to determine, based on the plurality of temperature rise amounts, a plurality of time constants indicative of associations between temperature rise amounts and operating times of the solid-state circuit breaker operating at the plurality of predetermined operating currents, respectively.

In some embodiments, the apparatus 700 further includes: a first constant determination module 750 configured to determine a first time constant and a second time constant of the plurality of time constants respectively corresponding to a first operating current and a second operating current; and a second constant determination module 760 configured to determine, based on the first operating current, the second operating current, the first time constant, the second time constant, and a third operating current, a third time constant indicative of an association between a temperature rise amount and an operating time of the solid-state circuit breaker operating at the third operating current, the plurality of predetermined operating currents excluding the third operating current.

In some embodiments, the apparatus 700 further includes: a duration determination module 770 configured to determine, based on comparisons between the plurality of temperature rise amounts and the predetermined threshold, a plurality of operating durations of the solid-state circuit breaker in accordance with the plurality of temperature rise amounts reaching the predetermined threshold, respectively; and a relationship determination module configured to determine an association relationship between the plurality of operating durations and the plurality of predetermined operating currents.

In some embodiments, the circuit breaker control module 740 includes: a third duration determination module 741 configured to determine, based on the association relationship, a third duration for which the solid-state circuit breaker has operated in accordance with the temperature rise amount of the solid-state circuit breaker operating at the first operating current of the plurality of predetermined operating currents reaching the predetermined threshold; and a circuit breaker turn-off module 742 configured to control the solid-state circuit breaker to be turned off in response to the solid-state circuit breaker has operated for the third duration.

In some embodiments, the time constant includes a first-type time constant and a pair of second-type time constants, and the first temperature rise amount determination module 720 includes: a first determination module 721 configured to determine the first temperature rise amount based on the temperature rise amount detected before the solid-state circuit breaker is turned off, the duration for which the solid-state circuit breaker is turned off, and the first-type time constant, or a second determination module 722 configured to determine the first temperature rise amount based on the temperature rise amount detected before the solid-state circuit breaker is turned off, the duration for which the solid-state circuit breaker is turned off, and the pair of second-type time constants.

In some embodiments, the second temperature rise amount determination module 730 includes a third determination module 731 configured to determine the second temperature rise amount based on the first temperature rise amount, the first-type time constant, and the operating current detected after the solid-state circuit breaker is turned on.

The units included in the apparatus 700 may be implemented in various manners, including software, hardware, firmware, or any combination thereof. In some embodiments, one or more units may be implemented using software and/or firmware, such as machine-executable instructions stored on a storage medium. In addition to or as an alternative to machine-executable instructions, some or all of the elements in the apparatus 700 may be implemented, at least in part, by one or more hardware logic components. By way of example and not limitation, example types of hardware logic components that may be used include field programmable gate arrays (FPGAs), application specific integrated circuits (ASICs), application specific standard products (ASSPs), system-on-a-chips (SOCs), complex programmable logic devices (CPLDs), and the like.

FIG. 8 illustrates a block diagram of an electronic device 800 in which one or more embodiments of the present disclosure may be implemented. It should be understood that the electronic device 800 illustrated in FIG. 8 is merely illustrative and should not constitute any limitation on the functionality and scope of the embodiments described herein. The electronic device 800 shown in FIG. 8 may be configured to implement the control unit 110 in FIG. 1.

As shown in FIG. 8, the electronic device 800 is in the form of a general-purpose electronic device. Components of the electronic device 800 may include, but are not limited to, one or more processors or processing units 810, a memory 820, a storage device 830, one or more communication units 840, one or more input devices 850, and one or more output devices 880. The processing unit 810 may be an actual or virtual processor and capable of performing various processes according to programs stored in the memory 820. In a multiprocessor system, a plurality of processing units execute computer-executable instructions in parallel to improve the parallel processing capability of the electronic device 800.

The electronic device 800 generally includes a plurality of computer storage media. Such media may be any available media accessible to the electronic device 800, including, but not limited to, volatile and non-volatile media, removable and non-removable media. The memory 820 may be a volatile memory (e.g., a register, a cache, a random access memory (RAM)), a non-volatile memory (e.g., a read-only memory (ROM), an electrically erasable programmable read-only memory (EEPROM), a flash memory), or some combination thereof. The storage device 830 may be a removable or non-removable medium and may include a machine-readable medium, such as a flash drive, a magnetic disk, or any other medium, which may be capable of storing information and/or data (e.g., training data for training) and may be accessed within the electronic device 800.

The electronic device 800 may further include additional removable/non-removable, volatile/non-volatile storage media. Although not shown in FIG. 8, a disk drive for reading from or writing into a removable, nonvolatile magnetic disk (e.g., a "floppy disk") and an optical disk drive for reading from or writing into a removable, nonvolatile optical disk may be provided. In these cases, each drive may be connected to a bus (not shown) by one or more data media interfaces. The memory 820 may include a computer program product 825 having one or more program modules configured to perform various methods or actions of various embodiments of the present disclosure.

The communication unit 840 is configured to communicate with another electronic device through a communication medium. Additionally, the functionality of components of the electronic device 800 may be implemented in a single computing cluster or multiple computing machines capable of communicating through a communication connection. Thus, the electronic device 800 may operate in a networked environment using logical connections with one or more other servers, network personal computers (PCs), or another network node.

The input device 850 may be one or more input devices, such as a mouse, a keyboard, a trackball, or the like. The output device 880 may be one or more output devices, such as a display, a speaker, a printer, or the like. The electronic device 800 may also communicate with one or more external devices (not shown) through the communication unit 840 as needed, and the external device such as a storage device, a display device, etc., communicates with one or more devices that enable a user to interact with the electronic device 800, or communicate with any device (e.g., a network card, a modem, etc.) that enables the electronic device 800 to communicate with one or more other electronic devices. Such communication may be performed via an input/output (I/O) interface (not shown).

According to example implementations of the present disclosure, there is provided a computer-readable storage medium having one or more computer instructions stored thereon, where one or more computer instructions are executed by a processor to implement the method described above. According to example implementations of the present disclosure, a computer program product is further provided. The computer program product is tangibly stored on a non-transitory computer-readable medium and includes computer-executable instructions, and the computer-executable instructions are executed by a processor to implement the method described above.

Aspects of the present disclosure are described herein with reference to flowchart(s) and/or block diagram(s) of a method, an apparatus (system), and a computer program product implemented according to the present disclosure. It should be understood that each block of the flowchart(s) and/or block diagram(s), and combination(s) of blocks in the flowchart(s) and/or block diagram(s), may be implemented by computer readable program instructions.

These computer-readable program instructions may be provided to a processing unit of a general purpose computer, special purpose computer, or other programmable data processing apparatus to produce a machine, such that the instructions, when executed by a processing unit of a computer or other programmable data processing apparatus, produce means to implement the functions/acts specified in the flowchart(s) and/or block diagram(s). These computer-readable program instructions may also be stored in a computer-readable storage medium, and these instructions cause the computer, programmable data processing apparatus, and/or other devices to work in a particular manner, such that the computer-readable medium storing instructions includes an article of manufacture including instructions to implement aspects of the functions/acts specified in the flowchart(s) and/or block diagram(s).

The computer-readable program instructions may also be loaded onto a computer, other programmable data processing apparatus, or other apparatus, such that a series of operational steps are performed on the computer, other programmable data processing apparatus, or other apparatus to produce a computer-implemented process such that the instructions executed on the computer, other programmable data processing apparatus, or other apparatus implement the functions/acts specified in one or more blocks in flowchart(s) and/or block diagram(s).

The flowchart(s) and block diagram(s) in the figures show architecture, functionality, and operation of possible implementations of systems, methods, and computer program products according to various implementations of the present disclosure. In this regard, each block in the flowchart(s) or block diagram(s) may represent a system, program segment, or portion of an instruction that includes one or more executable instructions for implementing the specified logical function. In some alternative implementations, the functions noted in the blocks may also occur in a different order than noted in the figures. For example, two consecutive blocks may actually be performed substantially in parallel, which may sometimes be performed in the reverse order, depending on the functionality involved. It is also noted that each block in the block diagram(s) and/or flowchart(s), as well as combination(s) of blocks in the block diagram(s) and/or flowchart(s), may be implemented with a dedicated hardware-based system that performs the specified functions or actions, or may be implemented in a combination of dedicated hardware and computer instructions.

Various implementations of the present disclosure have been described above, which are illustrative, not exhaustive, and are not limited to the implementations disclosed. Many modifications and variations will be apparent to those of ordinary skill in the art without departing from the scope of the various implementations illustrated. The selection of the terms used herein is intended to best explain the principles of the implementations, practical applications, or improvements to techniques in the marketplace, or to enable others of ordinary skill in the art to understand the various implementations disclosed herein.

**Claims**

1.  An over-temperature protection method (600) for a solid-state circuit breaker, comprising:

    determining (610) a time constant indicative of an association between a temperature rise amount and an operating time of the solid-state circuit breaker operating at a predetermined operating current, wherein the temperature rise amount indicates a change value of a device temperature of the solid-state circuit breaker at the predetermined operating current, and the predetermined operating current is no less than a rated operating current of the solid-state circuit breaker;

    determining (620) a first temperature rise amount of the solid-state circuit breaker based on a temperature rise amount detected before the solid-state circuit breaker is turned off, a duration for which the solid-state circuit breaker is turned off, and the time constant, wherein the first temperature rise amount indicates a current change value of the device temperature of the solid-state circuit breaker after the solid-state circuit breaker has operated for a first duration;

    determining (630) a second temperature rise amount of the solid-state circuit breaker based on the first temperature rise amount, the time constant, and an operating current detected after the solid-state circuit breaker is turned on, wherein the second temperature rise amount indicates a change value of a device temperature of the solid-state circuit breaker after the solid-state circuit breaker has operated for a second duration; and

    controlling (640) a turn-on state of the solid-state circuit breaker based on a comparison between the second temperature rise amount and a predetermined threshold.

2.  The over-temperature protection method (600) of claim 1, wherein the predetermined operating current is one of a plurality of predetermined operating currents, and determining (610) the time constant indicative of the association between the temperature rise amount and the operating time of the solid-state circuit breaker operating at the predetermined operating current comprises:

    determining a plurality of temperature rise amounts of the solid-state circuit breaker operating at the plurality of predetermined operating currents, each of the plurality of temperature rise amounts corresponding to one of the plurality of predetermined operating currents; and

    determining, based on the plurality of temperature rise amounts, a plurality of time constants indicative of associations between temperature rise amounts and operating times of the solid-state circuit breaker operating at the plurality of predetermined operating currents, respectively.

3.  The over-temperature protection method (600) of claim 2, further comprising:

    determining a first time constant and a second time constant of the plurality of time constants respectively corresponding to a first operating current and a second operating current; and

    determining, based on the first operating current, the second operating current, the first time constant, the second time constant, and a third operating current, a third time constant indicative of an association between a temperature rise amount and an operating time of the solid-state circuit breaker operating at the third operating current, the plurality of predetermined operating currents excluding the third operating current.

4.  The over-temperature protection method (600) of claim 2, further comprising:

determining, based on comparisons between the plurality of temperature rise amounts and the predetermined threshold, a plurality of operating durations of the solid-state circuit breaker in accordance with the plurality of temperature rise amounts reaching the predetermined threshold, respectively; and

determining an association relationship between the plurality of operating durations and the plurality of predetermined operating currents.

5. The over-temperature protection method (600) of claim 4, wherein controlling the turn-on state of the solid-state circuit breaker comprises:

determining, based on the association relationship, a third duration for which the solid-state circuit breaker has operated in accordance with the temperature rise amount of the solid-state circuit breaker operating at the first operating current of the plurality of predetermined operating currents reaching the predetermined threshold; and controlling the solid-state circuit breaker to be turned off in response to the solid-state circuit breaker having operated for the third duration.

6. The over-temperature protection method (600) of claim 1, wherein the time constant comprises a first-type time constant and a pair of second-type time constants, and determining (620) the first temperature rise amount of the solid-state circuit breaker comprises:

determining the first temperature rise amount based on the temperature rise amount detected before the solid-state circuit breaker is turned off, the duration for which the solid-state circuit breaker is turned off, and the first-type time constant; or

determining the first temperature rise amount based on the temperature rise amount detected before the solid-state circuit breaker is turned off, the duration for which the solid-state circuit breaker is turned off, and the pair of second-type time constants.

7. The over-temperature protection method (600) of claim 6, wherein determining the second temperature rise amount of the solid-state circuit breaker comprises:
determining the second temperature rise amount based on the first temperature rise amount, the first-type time constant, and the operating current detected after the solid-state circuit breaker is turned on.

8. An over-temperature protection apparatus (700) for a solid-state circuit breaker, comprising:

a time constant determination module (710) configured to determine a time constant indicative of an association between a temperature rise amount and an operating time of the solid-state circuit breaker operating at a predetermined operating current, wherein the temperature rise amount indicates a change value of a device temperature of the solid-state circuit breaker at the predetermined operating current, and the predetermined operating current is no less than a rated operating current of the solid-state circuit breaker;
a first temperature rise amount determination module (720) configured to determine a first temperature rise amount of the solid-state circuit breaker based on a temperature rise amount detected before the solid-state circuit breaker is turned off, a duration for which the solid-state circuit breaker is turned off, and the time constant, wherein the first temperature rise amount indicates a current change value of the device temperature of the solid-state circuit breaker after the solid-state circuit breaker has operated for a first duration;
a second temperature rise amount determination module (730) configured to determine a second temperature rise amount of the solid-state circuit breaker based on the first temperature rise amount, the time constant, and an operating current detected after the solid-state circuit breaker is turned on, wherein the second temperature rise amount indicates a change value of a device temperature of the solid-state circuit breaker after the solid-state circuit breaker has operated for a second duration; and
a circuit breaker control module (740) configured to control a turn-on state of the solid-state circuit breaker based on a comparison between the second temperature rise amount and a predetermined threshold.

9. An electronic device (800), comprising:

at least one processing unit (810); and
at least one memory (820) coupled to the at least one processing unit (810) and storing instructions for execution by the at least one processing unit (810), the instructions, when executed by the at least one processing unit (810), causing the electronic device (800) to perform the method (600) of any of claims 1 to 7.

10. A computer-readable storage medium having a computer program stored thereon, wherein the computer program is executable by a processor to implement the method (600) of any of claims 1 to 7.

FIG. 1

200

210  230

220

| 1.3 TIMES In | | 1.5 TIMES In | | 2 TIMES In | | 2.5 TIMES In | | 3 TIMES In | | 3.5 TIMES In | | 4 TIMES In | | 4.5 TIMES In | | 5 TIMES In | | 6 TIMES In | |
|---|---|---|---|---|---|---|---|---|---|---|---|---|---|---|---|---|---|---|---|
| DURA-TION | TEMPER-ATURE RISE | DURA-TION | TEMPER-ATURE RISE | DURA-TION | TEMPER-ATURE RISE | DURA-TION | TEMPER-ATURE RISE | DURA-TION | TEMPER-ATURE RISE | DURA-TION | TEMPER-ATURE RISE | DURA-TION | TEMPER-ATURE RISE | DURA-TION | TEMPER-ATURE RISE | DURA-TION | TEMPER-ATURE RISE | DURA-TION | TEMPER-ATURE RISE |
| 1s | XX | 1s | XX | 1s | XX | 0.05s | XX | 0.05s | XX | 0.01s | XX | 0.01s | XX | 0.01s | XX | 0.01s | XX | 0.01s | XX |
| 2s | XX | 2s | XX | 2s | XX | 0.1s | XX | 0.1s | XX | 0.02s | XX | 0.02s | XX | 0.02s | XX | 0.02s | XX | 0.02s | XX |
| 3s | XX | 3s | XX | 3s | XX | 0.15s | XX | 0.15s | XX | 0.03s | XX | 0.03s | XX | 0.03s | XX | 0.03s | XX | 0.03s | XX |
| 4s | XX | 4s | XX | 4s | XX | 0.2s | XX | 0.2s | XX | 0.04s | XX | 0.04s | XX | 0.04s | XX | 0.04s | XX | 0.04s | XX |
| 5s | XX | 5s | XX | 5s | XX | 0.25s | XX | 0.25s | XX | 0.05s | XX | 0.05s | XX | 0.05s | XX | 0.05s | XX | 0.05s | XX |
| 6s | XX | 6s | XX | 6s | XX | 0.3s | XX | 0.3s | XX | 0.06s | XX | 0.06s | XX | 0.06s | XX | 0.06s | XX | 0.06s | XX |
| 7s | XX | 7s | XX | 7s | XX | 0.35s | XX | 0.35s | XX | 0.07s | XX | 0.07s | XX | 0.07s | XX | 0.07s | XX | 0.07s | XX |
| 8s | XX | 8s | XX | 8s | XX | 0.4s | XX | 0.4s | XX | 0.08s | XX | 0.08s | XX | 0.08s | XX | 0.08s | XX | 0.08s | XX |
| 9s | XX | 9s | XX | 9s | XX | 0.45s | XX | 0.45s | XX | 0.09s | XX | 0.09s | XX | 0.09s | XX | 0.09s | XX | 0.09s | XX |
| 10s | XX | 10s | XX | 10s | XX | 0.5s | XX | 0.5s | XX | 0.1s | XX | 0.1s | XX | 0.1s | XX | 0.1s | XX | 0.1s | XX |

FIG. 2

FIG. 3

FIG. 4

FIG. 5

600

610

DETERMINE A TIME CONSTANT INDICATIVE OF AN ASSOCIATION BETWEEN A TEMPERATURE RISE AMOUNT AND AN OPERATING TIME OF THE SOLID-STATE CIRCUIT BREAKER OPERATING AT A PREDETERMINED OPERATING CURRENT, WHEREIN THE TEMPERATURE RISE AMOUNT INDICATES A CHANGE VALUE OF A DEVICE TEMPERATURE OF THE SOLID-STATE CIRCUIT BREAKER AT THE PREDETERMINED OPERATING CURRENT, AND THE PREDETERMINED OPERATING CURRENT IS NO LESS THAN A RATED OPERATING CURRENT OF THE SOLID-STATE CIRCUIT BREAKER

620

DETERMINE A FIRST TEMPERATURE RISE AMOUNT OF THE SOLID-STATE CIRCUIT BREAKER BASED ON A TEMPERATURE RISE AMOUNT DETECTED BEFORE THE SOLID-STATE CIRCUIT BREAKER IS TURNED OFF, A DURATION FOR WHICH THE SOLID-STATE CIRCUIT BREAKER IS TURNED OFF, AND THE TIME CONSTANT, WHEREIN THE FIRST TEMPERATURE RISE AMOUNT INDICATES A CURRENT CHANGE VALUE OF THE DEVICE TEMPERATURE OF THE SOLID-STATE CIRCUIT BREAKER AFTER THE SOLID-STATE CIRCUIT BREAKER HAS OPERATED FOR A FIRST DURATION

630

DETERMINE A SECOND TEMPERATURE RISE AMOUNT OF THE SOLID-STATE CIRCUIT BREAKER BASED ON THE FIRST TEMPERATURE RISE AMOUNT, THE TIME CONSTANT, AND AN OPERATING CURRENT DETECTED AFTER THE SOLID-STATE CIRCUIT BREAKER IS TURNED ON, WHEREIN THE SECOND TEMPERATURE RISE AMOUNT INDICATES A CHANGE VALUE OF A DEVICE TEMPERATURE OF THE SOLID-STATE CIRCUIT BREAKER AFTER THE SOLID-STATE CIRCUIT BREAKER HAS OPERATED FOR A SECOND DURATION

640

CONTROL A TURN-ON STATE OF THE SOLID-STATE CIRCUIT BREAKER BASED ON A COMPARISON BETWEEN THE SECOND TEMPERATURE RISE AMOUNT AND A PREDETERMINED THRESHOLD

FIG. 6

700

710
TIME CONSTANT
DETERMINATION MODULE

720
FIRST TEMPERATURE RISE
AMOUNT DETERMINATION
MODULE

730
SECOND TEMPERATURE
RISE AMOUNT
DETERMINATION MODULE

740
CIRCUIT BREAKER
CONTROL MODULE

FIG. 7

800

PROCESSOR — 810

MEMORY — 820
825
PRODUCT
PROGRAM

STORAGE DEVICE — 830

COMMUNICATION
UNIT — 840

INPUT DEVICE — 850

OUTPUT DEVICE — 860

FIG. 8

Europäisches
Patentamt
European
Patent Office
Office européen
des brevets

## EUROPEAN SEARCH REPORT

**Application Number**

EP 26 30 5096

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 5 323451 B2 (FURUKAWA ELECTRIC CO LTD) 23 October 2013 (2013-10-23) | 1,2,4-6, 8-10 | INV. H02H3/093 |
| A | * paragraphs [0019] - [0020], [0057] - [0066]; figures 1-15 * | 3 | H02H6/00 H02H7/22 |
| | ----- | | H03K17/08 |
| X | CN 201 975 766 U (CHINA AEROSPACE TIMES ELECTRONICS CO LTD) 14 September 2011 (2011-09-14) | 1,2,4-10 | |
| A | * paragraphs [0002], [0048] - [0061]; figures 1-6 * | 3 | |
| | ----- | | |
| X | CN 103 094 875 A (CHINA AEROSPACE TIMES ELECTRONICS CORP) 8 May 2013 (2013-05-08) * paragraphs [0032] - [0039]; figures 1-5 * | 1,2,8-10 | |
| | ----- | | |
| A | US 2023/155408 A1 (LEMBERG NICHOLAS A [US] ET AL) 18 May 2023 (2023-05-18) * paragraphs [0046] - [0049]; figures 2-7 * | 1,8-10 | |
| | ----- | | **TECHNICAL FIELDS SEARCHED (IPC)** |
| A | US 8 299 767 B1 (TUOZZOLO CLAUDIO [US] ET AL) 30 October 2012 (2012-10-30) * columns 18, 21; figures 17, 22 * | 1,8-10 | H02H H03K |
| | ----- | | |
| A | US 2023/085119 A1 (XING JINLEI [CN]) 16 March 2023 (2023-03-16) * paragraphs [0039] - [0045]; claim 1; figures 1-4 * | 2,3 | |
| | ----- | | |
| A | US 2001/019299 A1 (GOTZIG BERNHARD [FR]) 6 September 2001 (2001-09-06) * paragraphs [0059] - [0061]; figure 6 * | 1,8-10 | |
| | ----- | | |

The present search report has been drawn up for all claims

| Place of search | Date of completion of the search | Examiner |
|---|---|---|
| Munich | 24 April 2026 | Gomes Guerreiro, G |

EPO FORM 1503 03.82 (P04C01)

## ANNEX TO THE EUROPEAN SEARCH REPORT
## ON EUROPEAN PATENT APPLICATION NO.

EP 26 30 5096

This annex lists the patent family members relating to the patent documents cited in the above-mentioned European search report.
The members are as contained in the European Patent Office EDP file on
The European Patent Office is in no way liable for these particulars which are merely given for the purpose of information.

24-04-2026

| Patent document cited in search report | | Publication date | Patent family member(s) | | Publication date |
|---|---|---|---|---|---|
| JP 5323451 | B2 | 23-10-2013 | JP | 5323451 B2 | 23-10-2013 |
| | | | JP | 2009142146 A | 25-06-2009 |
| CN 201975766 | U | 14-09-2011 | NONE | | |
| CN 103094875 | A | 08-05-2013 | NONE | | |
| US 2023155408 | A1 | 18-05-2023 | CA | 3235980 A1 | 19-05-2023 |
| | | | CN | 118216056 A | 18-06-2024 |
| | | | EP | 4430724 A1 | 18-09-2024 |
| | | | US | 2023155408 A1 | 18-05-2023 |
| | | | WO | 2023086261 A1 | 19-05-2023 |
| US 8299767 | B1 | 30-10-2012 | NONE | | |
| US 2023085119 | A1 | 16-03-2023 | CN | 115776095 A | 10-03-2023 |
| | | | EP | 4148930 A1 | 15-03-2023 |
| | | | US | 2023085119 A1 | 16-03-2023 |
| US 2001019299 | A1 | 06-09-2001 | CA | 2327206 A1 | 06-06-2001 |
| | | | CN | 1299146 A | 13-06-2001 |
| | | | EP | 1107416 A1 | 13-06-2001 |
| | | | ES | 2335641 T3 | 31-03-2010 |
| | | | FR | 2802019 A1 | 08-06-2001 |
| | | | US | 2001019299 A1 | 06-09-2001 |

EPO FORM P0459

For more details about this annex : see Official Journal of the European Patent Office, No. 12/82